Europäisches Patentamt

**European Patent Office**

Office européen des brevets

(11) Veröffentlichungsnummer : **0 031 001**
**B1**

(12) **EUROPÄISCHE PATENTSCHRIFT**

(45) Veröffentlichungstag der Patentschrift : **16.11.83**

(51) Int. Cl.³ : **G 11 C 11/40**

(21) Anmeldenummer : **80105782.9**

(22) Anmeldetag : **25.09.80**

(54) **Verfahren zur kapazitiven Lesesignalverstärkung in einem integrierten Halbleiterspeicher mit Speicherzellen in MTL-Technik.**

(30) Priorität : **22.12.79 DE 2951945**

(43) Veröffentlichungstag der Anmeldung :
**01.07.81 Patentblatt 81/26**

(45) Bekanntmachung des Hinweises auf die Patenterteilung : **16.11.83 Patentblatt 83/46**

(84) Benannte Vertragsstaaten :
**DE FR GB**

(56) Entgegenhaltungen :
**EP A 0 004 871**
**DE A 2 511 518**
**DE A 2 855 866**
**US A 3 736 477**
**US A 3 816 758**

(73) Patentinhaber : **International Business Machines Corporation**
**Old Orchard Road**
**Armonk, N.Y. 10504 (US)**

(72) Erfinder : **Brosch, Rudolf**
**Seestrasse 104**
**D-7032 Sindelfingen (DE)**
Erfinder : **Helmeier, Helmut**
**Auf der Breite 23**
**D-7033 Herrenberg (DE)**
Erfinder : **Klein, Wielfried**
**Ulmenstrasse 86**
**D-7031 Holzgerlingen (DE)**
Erfinder : **Wernicke, Friedrich**
**Herdlauchring 6**
**D-7036 Schönaich (DE)**

(74) Vertreter : **Rudolph, Wolfgang**
**Schönaicher Strasse 220**
**D-7030 Böblingen (DE)**

EP 0 031 001 B1

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

## Verfahren zur kapazitiven Lesesignalverstärkung in einem integrierten Halbleiterspeicher mit Speicherzellen in MTL-Technik

Die Erfindung betrifft ein Verfahren nach dem Oberbegriff des Anspruchs 1.

In den letzten Jahren hat auf dem Gebiet der logischen Verknüpfungsschaltungen und der integrierten Halbleiterspeicher in bipolarer Technik eine rege Entwicklung stattgefunden, die unter der Bezeichnung MTL (Merged Transistor Logic) oder auch $I^2L$ (Integrated Injection Logic) Eingang in die Fachliteratur gefunden hat. Dazu wird auf die Aufsätze im IEEE Journal auf Solid State Circuits, Bd. SC/7, Nr. 5, Oktober 1972, Seiten 340ff und 346ff, verwiesen.

Durch die EP-A- 4871 ist eine monolithisch integrierte Halbleiteranordnung zum Aufbau verbesserter MTL-Speicherzellen bekannt geworden, die mindestens eine MTL-Struktur aufweist, die ihrerseits eine Injektionszone (P1) und einen invertierenden Transistor (T1) enthält, wobei die Injektionszone (P1) und lateral dazu die Basiszone (P2) des gleichen ersten Leitungstyps in einer die Emitterzone des Transistors (T1) bildenden Halbleiterschicht (N1) des zweiten Leitungstyps angeordnet ist. Eine Speicherzelle besteht dabei aus zwei solchen MTL-Strukturen, wobei die Adressierung der Speicherzelle über die Injektionszonen und die gemeinsame Emitterzone der invertierenden Transistoren erfolgt, wobei beim Einschreiben durch Injektionen von Ladungsträgern über eine der beiden Injektionszonen der zugehörige invertierende Transistor leitend wird und beim Lesen der durch die von der Basiszone des leitenden Transistors in die zugehörige Injektionszone injizierten Ladungsträger hervorgerufene Strom abgefühlt wird.

Diese Speicherkonzepte mit bipolaren Transistoren zeichnen sich durch kurze Schaltzeiten aus und sind zum Aufbau von extrem hochintegrierten Speichern und logischen Schaltungsverbänden (PLA) besonders geeignet.

Speicher, die mit Speicherzellen aus bipolaren Transistoren aufgebaut sind, die eine MTL-Struktur aufweisen, verlangen zur Selektion einer Speicherzelle die Umladung von Bitdaten- und/oder Steuerleitungskapazitäten. Der Spannungshub der Bitleitungen entspricht dabei ungefähr dem Spannungshub der selektierten Wortleitungen. Wie bereits in der DE-PS 2 511 518 beschrieben ist, werden die kapazitiven Entladeströme über die Speicherzellen der selektierten Wortleitung und über den Wortleitungstreiber nach Masse abgeführt. Dies hat jedoch bei einer größeren Anzahl von Speicherzellen innerhalb einer hochintegrierten Speichermatrix den Nachteil, daß der Flächenbedarf der Treiberschaltkreise, die elektrische Verlustleistung für jeden Treiber und die Verzögerungszeit bei der Selektion der Wortleitung unverhältnismäßig groß wird, so daß die Vorteile der verwendeten MTL-Struktur dadurch teilweise wieder zunichte gemacht würden.

Um diesen Nachteil zu beseitigen, wurden bereits in der DE-OS 28 55 866 ein Verfahren zum Betreiben eines Halbleiterspeichers und eine Schaltungsanordnung vorgeschlagen, die diese Nachteile nicht mehr aufweisen. Das Verfahren ist dadurch charakterisiert, daß eine an sich bekannte Kontrollschaltung frühzeitig vor dem Selektieren für die Speichermatrix aufgrund eines Auswahlsignals gleichzeitig Steuersignale auf eine Entladeschaltung, die allen Speicherzellen gemeinsam ist, und auf Schalttransistoren abgibt, die daraufhin eingeschaltet werden, daß dadurch auf den Bitdaten- und -Steuerleitungen die Entladeströme der Leitungskapazitäten durch die Schalttransistoren fließen und über die Entladeschaltung gemeinsam abfließen.

Obwohl es durch dieses Entladeverfahren möglich ist, den minimalen Hub auf der Wortleitung zu verwenden, kapazitive Spitzenströme auf den Spannungsversorgungsleitungen zu verhindern und eine relativ hohe Integration ermöglicht wird, haben diese Lösungen folgende Nachteile :

Der Ablauf der Selektionsoperation und der Entladeoperation der Bitleitungen muß zeitlich nacheinander erfolgen. Der Anstieg des Abfühlstroms aus dem Abfühlschaltkreis nach der Selektion der Bitleitungen bestimmt mit maßgeblich die Zugriffszeit zur Speicherzelle. Die parallel arbeitenden Bit- und Wortleitungs-Potential-Transistoren müssen am Ende der Selektionszeit alle eingeschaltet sein, so daß sich die Zykluszeit des Speicherchips verlängert.

Die Zahl der erforderlichen Komponenten in den peripheren Schaltkreisen eines derartig aufgebauten Speichers ist auch noch zu hoch. Außerdem ist das gelieferte Lesesignal vom Gleichstrom abhängig, der von dem Lese-/Schreibverstärker geliefert wird. Um ein höheres und steileres Lese- und Schreibsignal bei Verringerung der Komponenten in den Lese- und Schreibschaltkreisen und eine Verringerung der erforderlichen Steuerleitungen zu erreichen, wurde bereits in der EP-A-0 020 995 ein Verfahren zum Lesen und Schreiben vorgeschlagen, das dadurch charakterisiert ist, daß der zum Lesen und/oder Schreiben der Speicherzellen erforderliche Strom nur durch die Entladung von Injektorkapazitäten der nicht angesteuerten Speicherzellen erzeugt und direkt den angesteuerten Speicherzellen zum Lesen und/oder Schreiben zugeführt wird. Die entstehenden Bitleitungs-Entladeströme werden zum Zwecke des Lesens und/oder Schreibens einer selektierten Speicherzelle des jeweiligen Bitleitungspaares benutzt. Die Entladeströme aus Bitleitungs- und Injektor-Sperrschichtkapazitäten der nicht selektierten Speicherzellen laden die Injektor-Diffusionskapazitäten der selektierten Zelle. Dabei erfolgt die Entladung dieser Diffusionskapazitäten über interne Zellströme, und zwar auf der sich im Aus-Zustand befindlichen Seite der Speicherzelle wesentlich rascher als auf der sich im Ein-Zustand befindlichen Seite, so daß das Lesesignal das Differenzsignal ist, das sich aus dem unterschiedlich raschen Abbau der Ladungen auf der Aus- und Einseite ergibt. Ein relativ großes Lesesignal wird dadurch erreicht, daß die MTL-Speicherzellen während des Lesens mit sehr kleinen Injektorströmen betrieben werden. In diesem Strombereich ist aber die Stromverstärkung der Zell-PNP-Transistoren noch nicht nennenswert abgefallen, so daß ein beträchtlicher Anteil des Stromes, der in die im Ein-Zustand befindliche Seite der Zelle fließt, rückinjiziert wird und damit das Lesesignal bewirkt. Obwohl der Anteil des rückinjizierten Stromes am Gesamtinjektionsstrom in die Ein-Seite relativ hoch ist, ist der Rückinjektionsstrom absolut jedoch klein. Dies bewirkt, daß das Lesesignal eine geringe Flankensteilheit hat.

Dies führt dazu, daß die Zugriffszeit eines derart betriebenen Speichers relativ groß ist und daß auch die Abhängigkeit der Betriebssicherheit von den Toleranzen der Schaltungskomponenten relativ groß ist.

Der Erfindung liegt deshalb die Aufgabe zugrunde, ein Verfahren zur kapazitiven Lesesignalverstärkung eines integrierten Halbleiterspeichers, dessen Speicherzellen aus Flipflops mit bipolaren Transistoren in MTL-Technik bestehen, zu schaffen, daß durch Beeinflussung der beiden auf die selektierten Bitleitungen einwirkenden Umladeströme die Anstiegsflanke des Lesesignals bedeutend verbessert, die Toleranzabhängigkeit von den Schaltungskomponenten verringert und die Zugriffszeit um ca. 20 % verbessert.

Die erfindungsgemäße Lösung ist im kennzeichnenden Teil des Anspruchs 1 charakterisiert.

Merkmale von Ausgestaltungen dieser Lösung ergeben sich aus dem kennzeichnenden Teil der Ansprüche 2-5.

Mit dem vorgeschlagenen Verfahren wird durch die kurzzeitige Erhöhung der Differenz der beiden auf die selektierten Bitleitungen einwirkenden Umladeströme die Steilheit der Anstiegsflanke des Lesesignals wesentlich verbessert. Rechneranalysen haben gezeigt, daß sich dadurch die Zugriffszeit in einem hochintegrierten MTL-Halbleiterspeicher um mehr als 20 % verringern läßt. Außerdem wird die Toleranzabhängigkeit wesentlich verringert und der technische Aufwand an Schaltungsmittel wird trotz alledem klein gehalten.

Die Erfindung wird nun anhand von in den Zeichnungen dargestellten Ausführungsbeispielen näher beschrieben.

In der Zeichnung bedeuten :

Figur 1 die prinzipielle Anordnung einer bekannten MTL-Speicherzelle in einer Speicherebene ;

Figur 2 ein neues teilweises Ersatzschaltbild einer MTL-Speicherzelle (nach Fig. 1) ;

Figur 3 ein neues Ersatz-Schaltbild, das aufzeigt, daß die Bitleitungskapazität und die Zell-Diffusionskapazität einen kapazitiven Spannungsteiler bilden ;

Figur 4 den Differenzstrom an den Eingängen einer selektierten Zelle mit zugehörigem Verlauf der Spannung an der Wortleitung für drei verschiedene experimentell ausgeführte Fälle ;

Figur 5 eine detailiertes Schaltbild mit bekannter MTL-Zelle und mit bekannten Treibern zur kapazitiven Lesesignalverstärkung und

Figur 6 ein Diagramm für den prinzipiellen Spannungsverlauf an verschiedenen Leitungen der Schaltung nach Fig. 5.

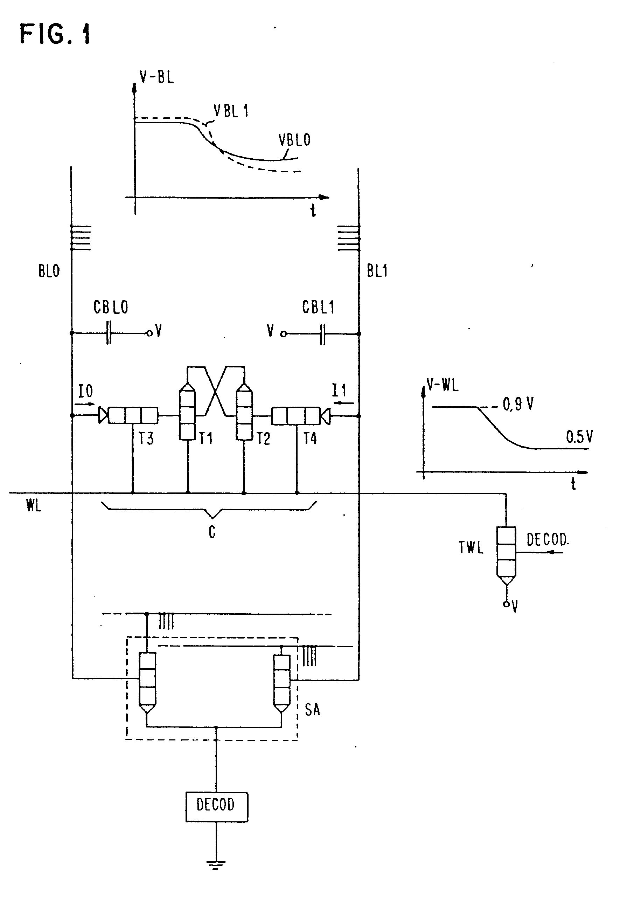

In Fig. 1 ist die prinzipielle Anordnung einer Speicherzelle C innerhalb einer Speicherebene mit den Wortleitungen WL, den Bitleitungen BL0 bzw. BL1, dem Leseverstärker SA und dem dazugehörigen Decoder dargestellt. Die Speicherzelle selbst besteht aus den beiden kreuzgekoppelten bipolaren Transistoren T1 und T2 sowie den beiden Koppeltransistoren T3 und T4, die an ihrer Basis mit der Wortleitung WL und mit ihren Emittern mit einer Bitleitung BL0 oder BL1 verbunden sind. Die Kollektoren der beiden Koppeltransistoren T3 und T4 sind mit der Basis der kreuzgekoppelten Transistoren T1 bzw. T2 verbunden. Die Kollektoren der beiden kreuzgekoppelten Transistoren T1 und T2 sind ebenfalls mit der Wortleitung WL verbunden. Diese ist ihrerseits mit einem Wortleitungstransistor TWL zum Ein- und Ausschalten verbunden, der an seiner Basis vom vorgeschalteten nicht dargestellten Decoder gesteuert wird.

Außerdem sind die beiden Bitleitungskapazitäten CBL0 und CBL1 für die Bitleitungen BL0 bzw. BL1 eingezeichnet. Im oberen Teil der Fig. 1 ist außerdem zwischen den Bitleitungen BL0 und BL1 der Spannungsverlauf V-BL an den Bitleitungen BL0 und BL1 in einem kleinen Diagramm gezeigt wie auch oberhalb des Wortleitungs-Transistors TWL der Spannungsverlauf V-WL auf der Wortleitung WL.

Damit sich an einem selektierten Bitleitungspaar BL0 und BL1 ein Lesesignal ausbilden kann, müssen die gezeigten Bitleitungskapazitäten CBL0 und CBL1 umgeladen werden. Diese Bitleitungskapazitäten CBL0 und CBL1 bestehen zu ungefähr 80 % aus Injektorkapazitäten der nicht selektierten Zellen und zu 20 % aus Metallkapazitäten. Bei einem 2K × 9 RAM mit 128 Speicherzellen an einer Bitleitung beträgt die Bitleitungskapazität beispielsweise ca. 12 pF.

Um bei einem Speicher mit den in Fig. 1 dargestellten Speicherzellen ein hohes und steiles Lesesignal zu erreichen, soll die Differenz der Umladeströme von den Bitleitungskapazitäten CBL0 und CBL1 möglichst groß sein. Diese Differenz ergibt sich aus dem Rückinjektionsstrom des gesättigten Zell-PNP-Transistors. Bei heute üblichen PNP-Transistoren ergeben sich günstige Werte für den Rückinjektionsstrom nur bei niedrigen Leseströmen, da bei hohen Leseströmen die Stromverstärkung dieses PNP-Transistors stark abfällt. Entsprechend flach ist dann auch der Verlauf der Anstiegsflanke des Lesesignals. Eine steilere Anstiegsflanke des Lesesignals ist aber wie bereits dargelegt wurde, sehr wünschenswert, da dadurch die Zugriffszeit und die Toleranz der Zugriffszeit sowie die Toleranz von den Schaltungskomponenten verringert wird.

Durch eine kurzzeitige Erhöhung der Differenz der beiden auf die selektierten Bitleitungen BL0 und BL1 einwirkenden Umladeströme I0 und I1 wird, wie noch näher beschrieben wird, die Anstiegsflanke des Lesesignals bedeutend vergrößert. Rechneranalysen haben gezeigt, daß sich dadurch die Zugriffszeit bei einem MTL-Speicher sogar um mehr als 20 % verringern läßt.

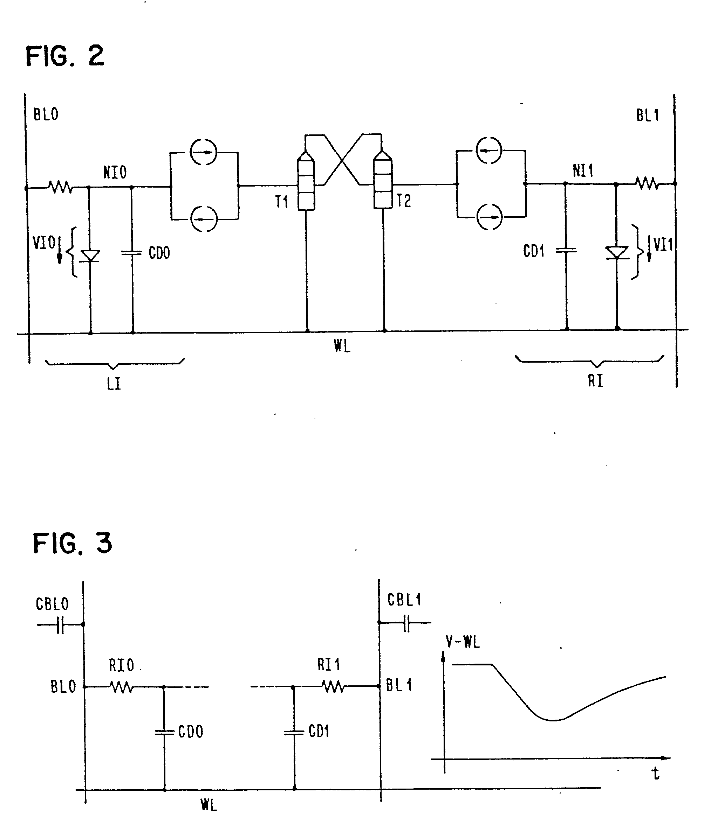

Die Erklärung der prinzipiellen Wirkungsweise und die erfindungsgemäßen Maßnahmen werden nun anhand der in den Fig. 2 und 3 dargestellten Ersatzschaltbilder eingehend erklärt.

Zur Selektion wird die Spannung V-WL (Fig. 3) auf der Wortleitung WL um ungefähr 400 mV heruntergezogen, wodurch beim Lesen über beide Injektoren ein kapazitiver Lesestrom aus den Bitleitungskapazitäten CBL0 und CBL1 in die selektierte Speicherzelle fließt. Die Diffusionskapazitäten CD0 und CD1 werden dabei vom Lesestrom um die gleiche Ladung aufgeladen. Entsprechend der im Zell-Flipflop gespeicherten Information wird einer der beiden PNP-Transistoren in Sättigung betrieben, während der andere im aktiven Bereich arbeitet (siehe Fig. 2). Durch die Rückinjektion beim gesättigten Transistor erfolgt der Ladungsabbau in der Diffusionskapazität CD0 oder CD1 auf der gesättigten Seite langsamer als auf der aktiven Seite. Das auf diese Weise über die Injektoren entstehende Differenzsignal ist relativ klein und besitzt eine flache Anstiegsflanke.

Da das Differenzsignal an der Speicherzelle gleich dem Unterschied der Spannungen VI0 und VI1 über beiden Injektordioden ist, sind die Diffusionskapazitäten CD0, CD1 des rechten und linken Injektors unterschiedlich groß.

$$CD = QS \times \frac{q}{kT} \times e^{\frac{q \times VJ}{kT}}$$

Schon bei einer Spannungsdifferenz von VI0 − VI1 = 4 mV, ergibt sich ein 17 %iger Unterschied in der Größe der Diffusionskapazitäten CD0 und CD1.

$$\frac{CD0}{CD1} = e^{\frac{q}{kT} \times (VJ0 - VJ1)}$$

$$= e^{\left(\frac{4}{26}\right)} = 1{,}17$$

Dadurch, daß unterschiedlich große Spannungen über den PNP-Sperrschichten der Injektoren liegen, ist auch die in den Diffusionskapazitäten CD0 und CD1 gespeicherte Ladung unterschiedlich groß.

$$Q = QS \times e^{\frac{q \times VJ}{kT}}$$

Die Ladung in der Kapazität des Injektors ist mit höherem Potential demnach größer.

Im nachfolgenden wird nun gezeigt, daß durch die unterschiedlich große gespeicherte Ladung in den beiden Injektorkapazitäten die Erhöhung des Spitzenwertes und eine Verbesserung der Flankensteilheit des Lesesignals erreicht wird.

Dies geschieht, das Potential der selektierten Wortleitung WL, nachdem es entsprechend den bisher üblichen Verfahren beim Adressieren um einem bestimmten Betrag (im Ausführungsbeispiel ca. 400 mV) abgesenkt wurde, wieder um einen bestimmten Wert schnell hochgeladen wird. Durch dieses Hochladen der selektierten Wortleitung WL wird gleichzeitig das Potential an der N-Seite beider PN-Injektoren angehoben. Dann bilden die Injektorkapazitäten CD0 und CD1 der selektierten Zellen und die Bitleitungskapazitäten CBL0 und CBL1 wie bei der Selektion wieder einen kapazitiven Spannungsteiler, wie aus Fig. 3 deutlich zu ersehen ist. Aufgrund der unterschiedlichen Größe beider Injektorkapazitäten CD0 und CD1 werden die beiden Bitleitungen BL0 und BL1 verschieden stark umgeladen und somit wird eine Verbesserung des Lesesignals erreicht. Um diese Aussage zu erhärten, wird im nachfolgenden ein vereinfachtes Zahlenbeispiel angegeben. Dabei wird angenommen, daß die gesamte Bitleitungskapazität

$$CBL0 = CBL1 = CBL = 10 \text{ pF}.$$

Für die Diffusionskapazität CD0, die während des Herunterschaltens der selektierten Wortleitung WL auf einen Maximalwert von über 30 pF ansteigt, wird zur Vereinfachung der Rechnung ein mittlerer konstanter Wert von 10 pF angenommen.

Die Lesespannung vor dem Hochladen der Wortleitung WL wird im vorliegenden Beispiel mit

$$VS = VBL1 - VBL0 = 4 \text{ mV}$$

angenommen.

Dies entspricht einer mittleren Diffusionskapazität

$$CD1 = CD0 \cdot e^{\frac{q^{VS}}{kT}} = 11{,}7 \text{ pF}$$

4

mit einem Wortleitungshub von

$$\Delta VWL = 400\ mV$$

ergibt sich dann :

$$\Delta VBL0 = \frac{\Delta Q0}{CBL} = \frac{1}{CBL} \cdot \frac{\Delta VWL}{\frac{1}{CD0} + \frac{1}{CBL}} = \frac{0,4\ V}{\frac{10}{10} + 1} = 0,2\ V$$

$$\Delta VBL1 = \frac{\Delta Q1}{CBL} = \frac{1}{CBL} \cdot \frac{\Delta VWL}{\frac{1}{CD1} + \frac{1}{CBL}} = \frac{0,4\ V}{\frac{10}{11,7} + 1} = 0,216\ V$$

d. h., das Lesesignal vergrößert sich durch das Hochladen um

$$\Delta VS = \Delta VBL1 - \Delta VBL0 = 216 - 200 = 16\ mV,$$

womit sich das gesamte Lesesignal auf

$$VS + \Delta VS = 4 + 16 = 20\ mV$$

sehr wesentlich verbessert.

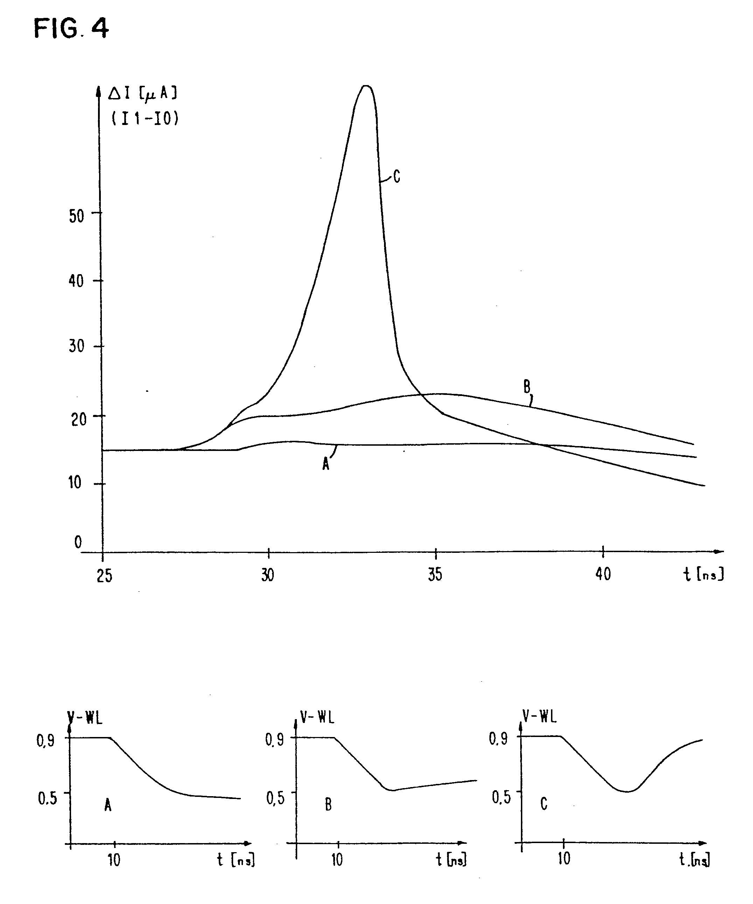

In dem Diagramm in Fig. 4 ist nun der zeitliche Verlauf der Differenz der beiden Injektorströme I0 und I1 einer selektierten Zelle dargestellt.

Aus diesem Diagramm nach Fig. 4 ist deutlich zu sehen, daß die Bitleitungskapazitäten CBL0 und CBL1 um so schneller umgeladen werden, je größer die Differenz der beiden Ströme I1 und I0 ist. Aus einer großen Differenz resultiert sehr schnell ein starkes Lesesignal.

Zur Erklärung sei nun hinzugefügt, daß aufgrund des Spannungsabfalls über den Injektorwiderständen RI0 und RI1 (Fig. 3) das Lesesignal an den Diffusionskapazitäten CD0 und CD1 früher anliegt als an den Bitleitungen BL0 bzw. BL1. Dies bedeutet, daß die Diffusionskapazitäten CD0 und CD1 schon einen deutlichen Unterschied zu einem Zeitpunkt aufweisen, zu dem das Lesesignal an den Bitleitungen BL0 und BL1 fast Null ist. Demzufolge wird vor dem Aufbau eines gültigen Lesesignals an den Bitleitungen BL0 und BL1 in den Diffusionskapazitäten CD0 und CD1 der beiden Zellinjektoren die benötigte Differenzladung schon gespeichert.

Die in Fig. 4 dargestellten Kurven zeigen im oberen Teil den Differenzstrom an den Eingängen einer selektierten Speicherzelle und in den unteren Diagrammen A bis C den zugehörigen Verlauf der Spannung V-WL an einer selektierten Wortleitung WL für drei verschiedene Fälle. Die Kurven sind das Ergebnis experimenteller Messungen und Untersuchungen an einem tatsächlich ausgeführten RAM.

Zunächst soll die Kurve A betrachtet werden, die den Verlauf von $\Delta I$ der Injektorströme I1 und I0 zeigt, wenn die Wortleitung WL nach der Adressierung auf einem konstanten Selektionspotential V-WL gehalten wird. Auf dieses Potential wird die selektierte Wortleitung WL um etwa 400 mV heruntergezogen, und zwar hier zwischen ca. 10 und 20 ns.

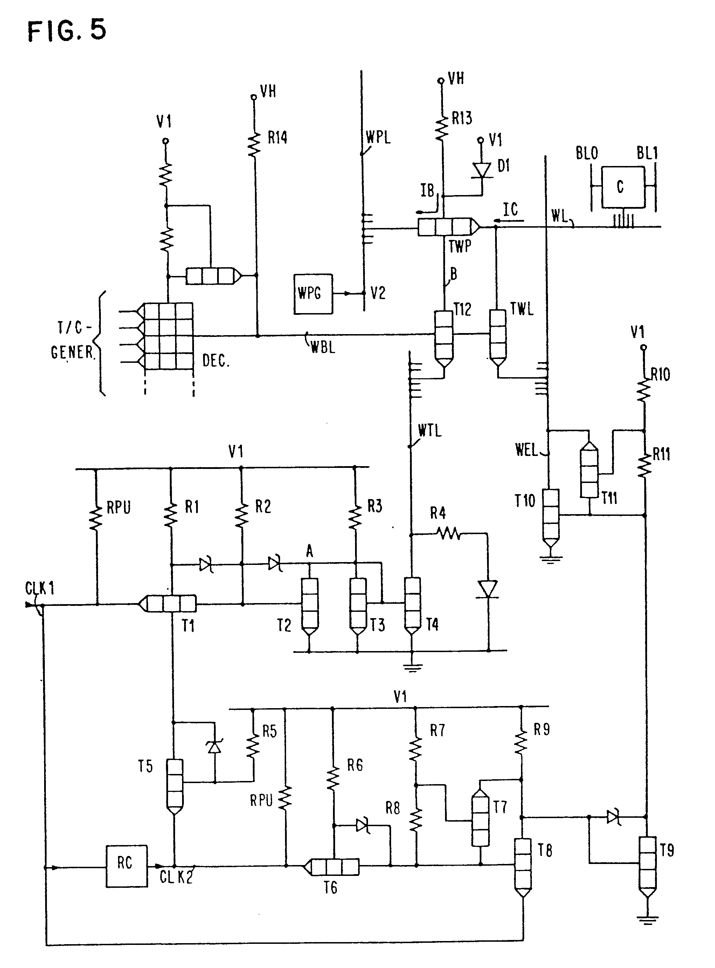

Die Anfangsbedingungen der Kurve B sind die gleichen wie die der Kurve A, aber zum Zeitpunkt t = 25 ns wird jetzt über einen Lesekontroll-Schaltkreis, dessen Verzögerung mit den übrigen Schaltkreisen mitläuft, der Wortleitungstransistor TWL abgeschaltet. Somit kann die selektierte Wortleitung WL von dem Strom der halbselektierten Speicherzellen an der gleichen Wortleitung WL langsam hochgeladen werden. Eine deutliche Vergrößerung von $\Delta I$ und damit eine entsprechende Verstärkung des Lesesignals zeigt die Kurve C. Im Fall C wird nicht nur wie im Fall B der Wortleitungstransistor TWL abgeschaltet, sondern es wird auch gleichzeitig noch die selektierte Wortleitung WL schnell hochgeladen, indem ein Transistor (in Fig. 5 der Transistor TWP) in der Worttreiberstufe eingeschaltet wird. Durch das wesentlich steilere Ansteigen der Anstiegsflanke des Lesesignals wird der Einfluß der Toleranzen der nachfolgenden Verstärkerstufe stark verringert, woraus sich eine wesentliche Verkürzung der Zugriffszeit des Speichers ergibt.

Die Speicherzellenstabilität wird durch die Anwendung der kapazitiven Lesesignalverstärkung nicht gefährdet. Da während des Einschaltens der Wortleitung WL die selektierte Speicherzelle stark überladen wird, ist auch im Fall C der Fig. 4 das interne Differenzsignal des Speicherzell-Flip-Flops am Ende der Selektionsphase immer noch mehr als 100 mV größer als im Ruhezustand. Die Anwendung dieses Verfahrens der kapazitiven Lesesignalverstärkung ermöglicht, wie gezeigt, eine Verringerung der Zugriffszeit um ungefähr 20 %, wobei auch der Schaltungsaufwand hierfür — wie nachfolgend gezeigt wird — äußerst klein gehalten wird.

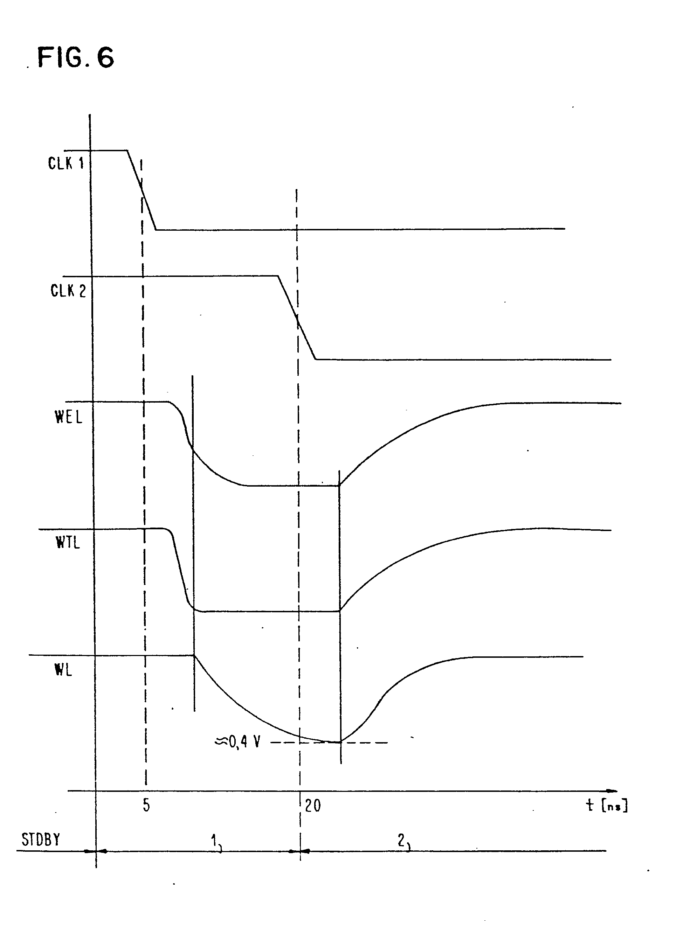

In Fig. 5 ist nun ein detailliertes Schaltbild zur kapazitiven Lesesignalverstärkung gezeigt. Die Wirkungsweise dieser Schaltung wird anhand des Impulsdiagramms der Fig. 6 erklärt, wobei zunächst angenommen wird, daß sich der Speicher im Ruhezustand befindet.

Während dieser Ruhezustands-Phase des Speichers werden die internen Takt-Signale CLK1 und CLK2 von Pull-Up-Widerständen RPU auf einem Pegel von 1,4 V gehalten. Damit sind die Transistoren T1, T5, T6 und T8 stromlos und die nachfolgenden Transistoren T2 und T9 in der Schaltung nach Fig. 5 sind eingeschaltet. Solange CLK1 den Emitter des Transistors T8 auf einem Potential hält, das über ca. 0,8 V liegt (V1 ≈ 1,4 V), bleibt der Transistor T8 ausgeschaltet und der Basisstrom kann von dem Widerstand R9 in die Basis des Transistors T9 fließen. Die Spannung am Kollektor des Transistors T9 steuert eine Klemmschaltung, die aus den Transistoren T10 und T11 sowie aus den Widerständen R10 und R11 besteht, mit der die Wort-Emitter-Leitung WEL auf ihren unteren Schaltpegel gezogen wird (siehe Fig. 6). Solange der Transistor T9 eingeschaltet ist, bleibt der Transistor T10 ausgeschaltet. Die Wort-Emitter-Leitung WEL wird von einem der Wort-Leitungs-Transistoren TWL auf dem Potential der Wortleitung WL festgehalten (die Wortbasisleitung WBL ist selektiert). Dann fließt ein Strom vom Widerstand R14 über die Basiskollektorstrecke des Transistors TWL und durch den gesättigten Transistor TWP in die Wortpotentialleitung WPL.

Wie anfangs erwähnt, ist im Ruhezustands-Betrieb der Transistor T1 in Fig. 5 ausgeschaltet, so daß der Transistor T2 den aus den Transistoren T3 und T4 bestehenden Stromspiegel inaktiv halten kann. Vernachlässigt man den sehr kleinen Strom durch den Widerstand R4, der im Ruhezustand die Wort-Trenn-Leitung WTL auf einen niedrigen Pegel halten soll, dann kann man den Transistor T12 als praktisch stromlos betrachten, und der gesamte Strom durch den Widerstand R13 steht als Basisstrom für den Wort-Potential-Transistor TWP zur Verfügung. Dieser Transistor ist in tiefer Sättigung und kann deshalb die zugehörige Wortleitung WL fest an die Wort-Potential-Leitung WPL ankoppeln. Die Spannung auf der Wort-Potential-Leitung WPL wird durch den Wort-Potential-Generator WPG auf ungefähr 1 V eingestellt. In Fig. 6 ist aus dem Diagramm zu ersehen, daß links der Potentialverlauf während der Ruhezustands-Phase STDBY, danach der Potentialverlauf wie er bisher in Schaltungen zur Lesesignalverstärkung auftrat (Abschnitt 1) und im Abschnitt 2 wie der Spannungsverlauf bei einem aktiven Hochschalten des Wort-Leitungs-Potentials verläuft, gezeigt ist.

Zunächst sei die Selektion der Wortleitung WL beschrieben. Nachdem die Ausgänge der T/C-Generatoren entsprechend den Adreß-Signalen auf einen festen Schaltzustand gesetzt wurden, wird durch Herunterschalten des internen Taktsignals CLK1 die Selektion einer Wortleitung WL eingeleitet. Sobald das Potential der Leitung mit dem Taktsignal CLK1 die Schwelle von 0,7 V unterschreitet, schalten die mit dieser Leitung verbundenen Transistoren T1 und T8 ein. Die Transistoren T5 und T6 bleiben hingegen weiterhin ausgeschaltet, da die Spannung des Taktsignals CLK2 noch bei 1,4 V liegt. Über den Transistor T8 wird der Transistor T9 ausgeschaltet, so daß die Spannung an der Basis vom Transistor T10 ansteigt. Dadurch schaltet der Transistor T10 ein und zieht die Wort-Emitter-Leitung WEL auf den durch den Widerstands-Teiler, bestehend aus den Widerständen R10 und R11, eingestellten unteren Schaltpegel von ungefähr 0,35 V.

Zur gleichen Zeit wird durch das Ausschalten des Transistors T2 der Stromspiegel, bestehend aus den Transistoren T3 und T4-aktiviert. Da der Kollektor des Transistors T4 über die Wort-Trenn-Leitung WTL an den Emitter des Transistors T12 liegt, wird der Basisstrom des Wort-Potential-Transistors TWP über den Transistor T12 abgezogen. Das Basispotential des Wortpotentialtransistors TWP fällt auf den durch die Klemmdiode D1 festgelegten Spannungswert von ungefähr 0,6 V. Dadurch wird der Wort-Potential-Transistor TWP ausgeschaltet und die Wortleitung WL kann von dem Wort-Leitungs-Transistor TWL auf ihr Selektionspotential von ungefähr 0,4 V heruntergezogen werden. Durch das schnelle Herunterziehen der Wortleitung WL werden die internen Kapazitäten der selektierten Speicherzellen stark aufgeladen und ein Lesesignal beginnt sich mit einer gewissen Verzögerung an den Bitleitungen BL0 und BL1 aufzubauen.

Im nachfolgenden wird nun die Verstärkung des Lesesignals durch das aktive Hochschalten der selektierten Wortleitung WL beschrieben. Dies entspricht dem Abschnitt 2 im Diagramm der Fig. 6.

Solange das Potential des Taktsignals CLK2 über dem Schwellwert von 0,7 V liegt, entspricht der Spannungsverlauf auf den Wort und Bitleitungen WL bzw. BL0 und BL1 in Schaltungen, wie sie bisher verwendet wurden (Abschnitt 1 in Fig. 6). Erst durch das kontrolliert verzögerte Herunterschalten des Taktsignals CLK2 auf der entsprechenden Leitung wird die Schaltungsoperation zur Verstärkung der Flankensteilheit und zur Erhöhung des Spitzenwertes des Lesesignals eingeleitet.

Während die Spannung des Taktsignals CLK1 zu Beginn des Lesevorgangs unter den Wert von 0,7 V abfällt, wird im Lesekontroll-Schaltkreis RC eine nicht dargestellte Verzögerungsschaltung getriggert, deren Ausgang nach ungefähr 15 ns die Leitung, die das Taktsignal CLK2 führt, auf ihren unteren Schaltpegel von 0,2 V herunterzieht. Dadurch werden die beiden mit dieser Leitung verbundenen Transistoren T5 und T6 eingeschaltet, die anschließend die mit der Leitung für das Taktsignal CLK1 verbundenen Transistoren T1 und T8 sperren.

Daraufhin steigt das Kollektorpotential des Transistors T8 bis zum Einschaltpunkt des Transistors T9 an. Der Kollektorstrom von T9 verringert die Spannung an der Basis des Transistors T10, wodurch dieser sperrt und der Zellstrom der selektierten und halbselektierten Speicherzellen C, der bis dahin über den Wort-Leitungs-Transistor TWL und den Transistor T10 nach Masse abgeführt wurde, beginnt das Potential auf der Wortleitung WL schnell hochzuladen.

Praktisch gleichzeitig mit dem Sperren des Transistors T10 wird der Stromspiegel, bestehend aus den Transistoren T3 und T4, vom Transistor T2 ausgeschaltet. Der Transistor T12 wird stromlos, und das Basispotential des Wort-Potential-Transistors TWP wird von dem Strom durch den Widerstand R13

6

hochgezogen. Sobald die Spannung an der Basis des Wort-Potential-Transistors TWP auf ungefähr 0,7 V über das Potential der selektierten Wortleitungen WL angestiegen ist, schaltet er ein und die Wortleitung WL wird entsprechend dem Spannungsanstieg an der Basis des Transistors TWP auf die Spannung von 1 V der Wort-Potential-Leitung WPL hochgeladen. Während des Anstiegs des Wort-Leitungs-Potentials speisen die Injektorkapazitäten CD0 und CD1 der selektierten Zelle unterschiedlich große kapazitive Ströme in die Bitleitungen BL0 und BL1 ein, wodurch das relativ große Lesesignal mit steiler Anstiegsflanke aufgebaut wird (siehe Abschnitt 2 in Fig. 6).

**Ansprüche**

1. Verfahren zur kapazitiven Lesesignalverstärkung in einem integrierten Halbleiterspeicher mit Speicherzellen (C) in MTL-Technik, die aus zwei kreuzgekoppelten Transistoren (T1 und T2) sowie zwei Koppeltransistoren (T3 und T4) bestehen, die an ihrer Basis mit einer Wortleitung (WL) und mit ihren Emittern mit einer Bitleitung (BL0 oder BL1) verbunden sind, deren Kollektoren mit der Basis der kreuzgekoppelten Transistoren (T1 bzw. T2) verbunden sind, während die Kollektoren der beiden kreuzgekoppelten Transistoren (T1 und T2) mit einer Wortleitung (WL) verbunden sind, die ihrerseits mit einem Wortleitungstransistor (TWL) zum Ein- und Ausschalten verbunden ist, der an der Basis vom vorgeschalteten Decoder gesteuert wird, wobei die Bitleitungen paarweise mit einem als Differenzverstärker aufgebauten Lese-Schreibschaltkreis verbunden sind und beim Lesen ein kapazitiver Lesestrom aus den Bitleitungskapazitäten (CBL0 und CBL1) in die selektierte Speicherzelle fließt, dadurch gekennzeichnet, daß das Potential (V-WL) auf der Wortleitung (WL) nach einem kontrollierten starken Absenken zur Adressierung einer Zelle (C) um einen bestimmten Wert sofort wieder hochgeladen wird, wodurch gleichzeitig das Potential (VI0 und VI1) an der N-Seite beider PN-Injektoren angehoben wird, daß durch Injektorkapazitäten (CD0 und CD1) der selektierten Speicherzelle (C) und die Bitleitungskapazitäten (CBL0 und CBL1) ein kapazitiver Spannungsteiler gebildet wird, und daß die damit verbundenen Bitleitungen (BL0 und BL1) durch die unterschiedliche Größe der beiden Injektorkapazitäten (CD0 und CD1) sehr verschieden stark umgeladen werden, so daß das Differenzsignal an den Bitleitungen (BL0 und BL1) durch Einspeisung sehr unterschiedlich großer Ströme wesentlich verstärkt wird.

2. Verfahren nach Anspruch 1, dadurch gekennzeichnet, daß das als Lesesignal dienende Differenzsignal an der Speicherzelle (C) gleich dem Unterschied der Spannungen (VI0, VI1) über beiden Injektordioden ist, wodurch die Diffusionskapazitäten (CD0 und CD1) des rechten und linken Injektors einer Speicherzelle (C) unterschiedlich groß sind.

3. Verfahren nach den Ansprüchen 1 und 2, dadurch gekennzeichnet, daß die Schaltungsoperation zur Verstärkung der Flankensteilheit und zur Erhöhung des Spitzenwertes des Lesesignals durch ein kontrolliert verzögertes Herunterschalten des Potentials eines Taktsignals (CLK2) eingeleitet wird, und daß der Zellstrom der selektierten und der halbselektierten Speicherzellen (C) beginnt das Potential auf der Wortleitung (WL) hochzuladen, daß dadurch das Basispotential eines mit der Wortleitung (WL) und einer Wortpotentialleitung (WPL) verbundenen Wort-Potential-Transistors (TWP) hochgezogen wird, und daß bei einer Überschreitung der Spannung an der Basis dieses Transistors (TWP) um einen bestimmten Wert über das Potential der selektierten Wortleitung (WL) dieser eingeschaltet und die Wortleitung (WL) entsprechend dem Spannungsanstieg an der Basis auf die Spannung der Wort-Potential-Leitung (WPL) hochgeladen wird, wodurch während des Anstiegs des Potentials auf der Wortleitung (WL) die Injektorkapazitäten (CD0 und CD1) unterschiedlich große kapazitive Ströme in die Bitleitungen (BL0 und BL1) einspeisen.

4. Verfahren nach den Ansprüchen 1 bis 3, dadurch gekennzeichnet, daß während einer Ruhezustands-Phase (STDBY) die Taktsignale (CLK1 und CLK2) von Widerständen auf einen bestimmten Pegel festgehalten werden, daß dadurch damit beaufschlagte Transistoren (T1, T5, T6 und T8) stromlos sind, während nachfolgende Transistoren (T2 und T9) eingeschaltet sind, daß solange der Transistor (T8) ausgeschaltet ist, ein Basisstrom in die Basis eines nachgeschalteten Transistors (T9) fließt und daß eine Spannung am Kollektor dieses Transistors (T9) eine Klemmschaltung (T10), T11, R10 und R11) steuert, mit der eine Wort-Emitter-Leitung (WEL) auf ihren unteren Schaltpegel gezogen wird, daß der eine Transistor (T10) der Klemmschaltung solange ausgeschaltet bleibt wie der vorgeschaltete Transistor (T9) eingeschaltet ist und die Wort-Emitter-Leitung (WEL) von einem Wortleitungs-Transistor (TWL) auf dem Potential der Wortleitung (WL) festgehalten wird, daß ein Strom von einem Widerstand (R14) über die Basis-Kollektor-Strecke des Wortleitungs-Transistors (TWL) und durch den gesättigten Wort-Potential-Transistor (TWP) in eine Wort-Potential-Leitung (WPL) fließt, die mit einem Potentialgenerator (WPG) zur Einstellung eines Potentials (V2) verbunden ist, daß nach dem Einleiten der Selektion einer Wortleitung (WL) die beiden Transistoren (T5 und T6) die von den anderen Taktsignal (CLK2) gesteuert sind, ausgeschaltet bleiben, daß über den Transistor (T8) der nachgeschaltete Transistor (T9) ausgeschaltet wird, wodurch die Spannung an der Basis von Transistor (T10) ansteigt, daß dadurch die Wort-Emitter-Leitung (WEL) auf einen unteren Schaltpegel gezogen wird, während zur gleichen Zeit Stromspiegel (T3, T4) durch Ausschalten des Transistors (T2) aktiviert werden, daß der Kollektor des einen Transistors (T4) über eine Wort-Trennleitung (WTL) mit dem Emitter eines Transistors (T12) verbunden ist, wodurch der Basisstrom des Wort-Potential-Transistors (TWP) über diesen Transistor (T12) abgezogen wird und daß das Basis-Potential des Wort-Potential-Transistors (TWP) abfällt, der dadurch ausgeschaltet wird, wodurch die Wortleitung (WL) von dem Wortleitungs-Transistor (TWL) auf ihr Selektionspotential heruntergezogen wird.

5. Verfahren nach Anspruch 4, dadurch gekennzeichnet, daß durch das schnelle Herunterziehen des Potentials der Wortleitung (WL) die internen Kapazitäten der selektierten Speicherzellen (C) stark aufgeladen werden, und durch Rückinjektion im gesättigten PNP-Transistor (T3 oder T4) ein Lesesignal an den Bitleitungen (BL0 und BL1) mit einer Verzögerung aufgebaut wird, daß zu Beginn des Lesevorgangs die Spannung auf der das Taktsignal (CLK1) führenden Leitung abfällt, wodurch im Lese-Kontroll-Schaltkreis (RC) eine Verzögerungsschaltung getriggert wird, deren Ausgang nach einer bestimmten Zeit das Potential der das zweite Taktsignal (CLK2) führenden Leitung auf ihren unteren Schaltpegel herunterzieht, daß dadurch die beiden damit verbundenen Transistoren (T5 und T6) eingeschaltet werden, die anschließend die beiden mit dem ersten Taktsignal (CLK1) verbundenen Transistoren (T1 und T8) sperren, daß daraufhin das Kollektorpotential des Transistors (T8) bis zum Einschaltpunkt des nachgeschalteten Transistors (T9) ansteigt, daß der Kollektorstrom dieses Transistors die Spannung an der Basis des nachgeschalteten Transistors (T10) verringert, der daraufhin gesperrt wird, daß der Zellstrom der selektierten und halbselektierten Zellen, der bis dahin über den Wortleitungs-Transistor (TWL) und den Transistor (T10) nach Masse abgeführt wurde, beginnt das Potential auf der Wortleitung (WL) hochzuladen, daß praktisch gleichzeitig mit dem Sperren des Transistors (T10) der Stromspiegel (T3, T4) vom Transistor (T2) ausgeschaltet wird, daß der Transistor (T12) stromlos und das Basispotential des Wort-Potential-Transistors (TWP) hochgezogen wird, daß so bald die Spannung an der Basis des Wort-Potential-Transistors (TWP) einen bestimmten Wert über das Potential der selektierten Wortleitung (WL) angestiegen ist, der Wort-Potential-Transistor (TWP) einschaltet und die Wortleitung (WL) entsprechend dem Spannungsanstieg an der Basis dieses Transistors auf die Spannung der Wort-Potential-Leitung hochgeladen wird, und daß während des Anstiegs des Wortleitungs-Potentials die Injektorkapazitäten (CD0 und CD1) unterschiedlich große kapazitive Ströme in die Bitleitungen (BL0 und BL1) einspeisen.

**Claims**

1. A method for capacitive read signal amplification in an integrated semiconductor storage with storage cells (C) in MTL technology, which consist of two cross-coupled transistors (T1 and T2) as well as of two coupling transistors (T3 and T4) having their base connected to a word line (WL) and their emitters to a bit line (BL0 or BL1), and the collectors of which are connected to the base of the cross-coupled transistors (T1 and T2, respectively), whereas the collectors of the two cross-coupled transistors (T1 and T2) are connected to a word line (WL) which in turn is connected to a word line transistor (TWL) for switching on and switching off, the base of said word line transistor (TWL) being controlled by the preceding decoder, wherein the bit lines are connected in pairs to a read/write circuit designed as a differential amplifier, and wherein, upon reading, a capacitive read current from the bit line capacitances (CBL0 and CBL1) flows into the selected storage cell, characterized in that after a controlled strong lowering for addressing a cell (C), the potential (V-WL) on the word line (WL) is immediately recharged by a particular value, thus simultaneously raising the potential (VI0 and VI1) on the N side of both PN injectors, that the injector capacitances (CD0 and CD1) of the selected storage cells (C) and the bit line capacitances (CBL0 and CBL1) form a capacitive voltage divider, and that the bit lines (BL0 and BL1) connected thereto are differently charged as a result of the difference in magnitude of the two injector capacitances (CD0 and CD1), so that the difference signal on the bit lines (BL0 and BL1) is increased by the supply of currents of substantially different magnitudes.

2. The method according to claim 1, characterized in that the difference signal on the storage cell (C), which serves as a read signal, equals the difference of the voltages (VI0, VI1) across the two injector diodes, so that the diffusion capacitances (CD0 and CD1) of the right and the left injector of a storage cell (C) are of different magnitudes.

3. The method according to claims 1 and 2, characterized in that the switching operation for amplifying the edge steepness and for increasing the peak value of the read signal is obtained by a controlled and delayed pulling down of the potential of a clock signal (CLK2), and that the cell current of the selected and the semi-selected storage cells (C) starts charging up the potential on the word line (WL), so that, as a result, the base potential of a word potential transistor (TWP), connected to the word line (WL) and a word potential (WPL), is pulled up, and that if the voltage at the base of said transistor (TWP) is exceeded by a particular value which is above the potential of the selected word line (WL), said word potential transistor (TWP) is switched on, and the word line (WL) is charged up to the voltage of the word potential line (WPL) according to the voltage increase at the base, so that as the potential on the word line (WL) increases, the injector capacitances (CD0 and CD1) supply capacitive currents of different magnitudes to the bit lines (BL0 and BL1).

4. The method according to the claims 1 to 3, characterized in that during a standby phase (STDBY), the clock signals (CLK1 and CLK2) are kept by resistors at a particular level, that, as a result, transistors (T1, T5, T6 and T8), receiving said signals, are off, while the subsequent transistors (T2 and T9) are on, that for the time the transistor (T8) is off, a base current flows into the base of a subsequent transistor (T9), and that a voltage at the collector of said transistor (T9) controls a clamping circuit (T10, T11, R10 and R11), by means of which a word emitter line (WEL) is pulled to its lower switching level, that one transistor (T10) of the clamping circuit remains off as long as the preceding transistor (T9) is on and the word emitter line (WEL) is kept by a word line transistor (TWL) at the potential of the word line (WL), that a current from a resistor (R14) flows across the base collector junction of the word line transistor (TWL) and through the saturated word potential transistor (TWP) into a word potential line (WPL) which is connected to a potential generator (WPG) for setting a potential (V2), that after the selection of a word line (WL) has been initiated, the two transistors (T5 and T6), which are controlled by the other clock signal (CLK2), continue to be off, that, via the transistor (T8), the subsequent transistor (T9) is switched off, so that the voltage at the base of transistor (T10) increases, that, as a result, the word emitter line (WEL) is pulled to a lower switching level, while current mirrors (T3, T4) are activated by switching off the transistor (T2), that the collector of one transistor (T4) is connected to the emitter of a transistor (T12) via a word division line (WTL), so that the base current of the word potential transistor (TWP) is discharged via said transistor (T12), and that the base potential of the word potential transistor (TWP) drops, switching off the latter, so that the word line (WL) is pulled down to its selection potential by the word line transistor (TWL).

5. The method according to claim 4, characterized in that, as a result of the potential of the word line (WL) being rapidly pulled down, the internal capacitances of the selected storage cells (C) are heavily charged, reinjection in the saturated PNP transistor (T3 or T4) causing a read signal to be formed with a delay at the bit lines (BL0 and BL1), that at the beginning of the read process, the voltage on the line carrying the clock signal (CLK1) drops, triggering a delay circuit in the read control circuit (RC), by whose output the potential of the line carrying the second clock signal (CLK2) is pulled down to its lower switching level after a particular time, that, as a result, the two transistors (T5 and T6) connected thereto are switched on, subsequently blocking the two transistors (T1 and T8) connected to the first clock signal (CLK1), that the collector potential of the transistor (T8) rises until the subsequent transistor (T9) is switched on, that the collector current of said transistor (T9) reduces the voltage at the base of the subsequent transistor (T10), thus blocking the latter, that the cell current of the selected and the semi-selected cells, which up to that stage has been discharged to ground via the word line transistor (TWL) and the transistor (T10), starts charging the potential on the word line (WL), that practically concurrently with the blocking of transistor (T10), the current mirror (T3, T4) is switched off by transistor (T2), that the transistor (T12) is off and the base potential of the word potential transistor (TWP) is pulled up, that as soon as the voltage at the base of the word potential transistor (TWP) has increased to a value which is above the potential of the selected word line (WL), the word potential transistor (TWP) is switched on, and the word line (WL) is charged to the voltage of the word potential line according to the voltage increase at the base of said transistor, and that as the word line potential increases, the injector capacitances (CD0 and CD1) supply capacitive currents of different magnitudes to the bit lines (BL0 and BL1).

**Revendications**

1. Procédé d'amplification capacitive du signal de lecture dans une mémoire intégrée à semiconducteurs dont les cellules de mémoire (C), en technologie MTL, sont composées de deux transistors couplés en croix (T1 et T2) et de deux transistors de commutation (T3 et T4) dont les bases sont reliées à une ligne de mots (WL), dont les émetteurs sont reliés à la ligne de bits (BL0, BL1), et dont les collecteurs sont reliés à la base des transistors couplés en croix (T1, T2), tandis que les collecteurs des deux transistors (T1 et T2) sont reliés à une ligne de mots (WL) elle-même connectée à un transistor de ligne de mots (TWL) qui en assure la mise en et hors-circuit, la base dudit transistor de ligne de mot étant commandée par le décodeur branché en amont, les lignes de bits étant connectées par paires à un circuit de lecture-écriture monté en amplificateur différentiel, un courant capacitif de lecture provenant des condensateurs de lignes de bits (CBL0 et CBL1) parcourant lors de la lecture la cellule de mémoire sélectionnée, le procédé d'amplification capacitive du signal de lecture étant caractérisé en ce que le potentiel (V-WL) appliqué à la ligne de mots (WL) est immédiatement remonté à une valeur déterminée et ce, après une forte chute contrôlée lors de l'adressage d'une cellule (C), remontée entraînant simultanément une élévation du potentiel (VI0 et VI1) appliqué sur le côté N des deux injecteurs PN, en ce que les condensateurs d'injecteurs (CD0 et CD1) de la cellule de mémoire (C) sélectionnée et les condensateurs de lignes de bits (CBL0 et CBL1) constituent un diviseur capacitif de tension, et en ce que les lignes de bits (BL0 et BL1) ainsi reliées sont chargées différemment en raison des différences de valeurs des condensateurs d'injecteurs (CD0 et CD1) le signal différentiel sur les lignes de bits (BL0 et BL1) étant ainsi considérablement amplifié du fait des intensités très différentes des courants d'alimentation.

2. Procédé selon la revendication 1, caractérisé par le fait que le signal différentiel servant de signal de lecture sur la cellule de mémoire (C) est égal à la différence des tensions (VI0, VI1) aux bornes des deux diodes d'injecteur, les condensateurs de diffusion (CD0 et CD1) des injecteurs droit et gauche d'une cellule de mémoire (C) étant de valeurs différentes.

3. Procédé selon l'une des revendications 1 et 2, caractérisé par le fait que l'opération de commutation destinée à amplifier la pente du signal et à augmenter la valeur de crête du signal de lecture est amorcée par une réduction retardée et contrôlée du potentiel d'un signal d'horloge (CLK2), que le courant de cellule des cellules de mémoire sélectionnées et semi-sélectionnées (C) commence à augmenter le potentiel de la ligne de mots (WL), de telle sorte que le potentiel de base d'un transistor de potentiel de mots (TWP) relié à la ligne de mots (WL) et à une ligne de potentiel de mots (WPL) augmente et que le transistor (TWP) s'enclenche lorsque la tension appliquée sur sa base dépasse d'une valeur définie le potentiel de la ligne de mots sélectionnée (WL), et que ladite ligne (WL) est portée à la tension de la ligne de potentiel de mots (WPL) proportionnellement à l'augmentation de la tension de base et, qu'ainsi, au cours de l'augmentation du potentiel de ligne de mots (WL), les condensateurs d'injecteurs (CD0 et CD1) débitent des courants capacitifs d'intensités différentes dans les lignes de bits (BL0 et BL1).

4. Procédé selon une des revendications 1 à 3, caractérisé par le fait qu'au cours d'une phase d'état de repos (STDBY) les signaux d'horloge (CLK1 et CLK2) sont maintenus à un niveau précis par des résistances, que les transistors (T1, T5, T6, T8) ainsi alimentés sont hors-circuit tandis que les transistors placés en aval (T2 et T9) sont conducteurs qu'un courant de base circule dans la base d'un transistor aval (T9) aussi longtemps que le transistor (T8) reste hors-circuit, qu'une tension appliquée au collecteur de ce transistor (T9) commande un circuit de verrouillage, (T10, T11, R10, R11) fixant à son niveau bas de commutation une ligne d'émetteur de mots (WEL), que le transistor (T10) du circuit de verrouillage reste hors-circuit tant que le transistor amont (T9) est conducteur et que la ligne d'émetteur de mots (WEL) est maintenue au potentiel de la ligne de mots (WL) par un transistor de ligne de mots (TWL) qu'un courant circule d'une résistance (R14) dans une ligne de potentiel de mots (WPL), et ce, au travers de la jonction collecteur-base du transistor de ligne de mots (TWL) et du transistor saturé de potentiel de mots (TWP), ladite ligne (WPL) étant connectée à un générateur de tension (WPG) la plaçant à un potentiel (V2), qu'après l'amorçage de la sélection d'une ligne de mots (WL), les deux transistors (T5 et T6), commandés par l'autre signal d'horloge (CLK2), restent hors-circuit, que le transistor aval (T9) est mis hors-circuit par le transistor (T8), la tension appliquée sur la base du transistor (T10) augmentant de ce fait, que la ligne d'émetteur de mots (WEL) est ainsi forcée à un niveau bas de commutation, tandis qu'au même moment la mise hors-circuit du transistor (T2) active les miroirs de courant (T3, T4), que le collecteur du transistor (T4) est relié à l'émetteur d'un transistor (T12) par une ligne de séparation de mots (WTL), ce qui provoque la suppression du courant de base du transistor de potentiel de mots (TWP) au travers de ce transistor (T12), et que la tension appliquée à la base du transistor de potentiel de mots (TWP) diminue, ce transistor étant ainsi mis hors-circuit, et la ligne de mots (WL) étant de ce fait forcée vers le bas jusqu'à son potentiel de sélection par le transistor de ligne de mots (TWL).

5. Procédé selon revendication 4 caractérisé par le fait que l'abaissement rapide du potentiel de la ligne de mots (WL) provoque une forte charge des condensateurs internes des cellules de mémoire (C) sélectionnées, que la réinjection dans le transistor PNP saturé (T3 ou T4) provoque avec un certain retard, la formation d'un signal de lecture sur les lignes de bits (BL0 et BL1), qu'au début du processus de lecture la tension appliquée à la ligne portant le signal d'horloge (CLK1) diminue, déclenchant un circuit à retard dans le circuit de contrôle de lecture (RC), ledit circuit forçant après un temps déterminé, le potentiel de la ligne portant le deuxième signal d'horloge (CLK2) à son niveau bas de commutation, qu'ainsi, les deux transistors (T5 et T6) de ce fait reliés deviennent conducteurs, bloquant ensuite les deux transistors (T1 et T8) connectés au premier signal d'horloge (CLK1), que le potentiel de collecteur du transistor (T8) augmente jusqu'à ce que le transistor aval (T9) devienne conducteur, que le courant de collecteur de ce transistor (T9) diminue la tension appliquée sur la base du transistor aval (T10) qui se bloque, que le courant de cellule des cellules sélectionnées et semi-sélectionnées, jusqu'alors déchargé à la masse par le transistor de ligne de mots (TWL) et le transistor (T10), commence à augmenter le potentiel de la ligne de mots (WL), que le blocage du transistor (T10) provoque presque simultanément la mise hors-circuit du miroir de courant (T3, T4) par le transistor (T2), que le transistor (T12) est bloqué alors que le potentiel de la base du transistor de potentiel de mots (TWP) est augmenté, que, dès que la tension de base du transistor de potentiel de mots (TWP) est augmentée d'une valeur déterminée supérieure au potentiel de la ligne de mots sélectionnée (WL), le transistor de potentiel de mots (TWP) s'enclenche, et la ligne de mots (WL) est chargée à la tension de la ligne de potentiel de mots en fonction de l'augmentation de la tension appliquée sur la base de ce transistor, et que, pendant l'augmentation du potentiel de ligne de mots, les condensateurs d'injecteurs (CD0 et CD1) alimentent les lignes de bits (BL0 et BL1) par des courants capacitifs d'intensités différentes.

10

# FIG. 1

## FIG. 2

## FIG. 3

FIG. 4

# FIG. 5

**FIG. 6**